(19) Europäisches Patentamt
European Patent Office
Office européen des brevets

(11) EP 4 763 512 A1

(12) EUROPEAN PATENT APPLICATION
published in accordance with Art. 153(4) EPC

(43) Date of publication:
**24.06.2026 Bulletin 2026/26**

(21) Application number: **24854160.9**

(22) Date of filing: **08.08.2024**

(51) International Patent Classification (IPC):
***B32B 9/00*** *(2006.01)* ***H01L 21/31*** *(2006.01)*
***H01L 21/312*** *(2006.01)* ***H01L 21/316*** *(2006.01)*
***H01L 21/318*** *(2006.01)*

(52) Cooperative Patent Classification (CPC):
**B32B 9/00; H10P 14/60**

(86) International application number:
**PCT/JP2024/028361**

(87) International publication number:
**WO 2025/037570 (20.02.2025 Gazette 2025/08)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.08.2023 JP 2023132313**

(71) Applicant: **MITSUBISHI GAS CHEMICAL COMPANY, INC.**
**Chiyoda-ku**
**Tokyo 100-8324 (JP)**

(72) Inventors:
- **ABIKO Yohei**
  **Hiratsuka-shi, Kanagawa 254-0016 (JP)**
- **OKADA Kana**
  **Hiratsuka-shi, Kanagawa 254-0016 (JP)**
- **YASUFUKU Haruka**
  **Hiratsuka-shi, Kanagawa 254-0016 (JP)**
- **OGAWA Shun**
  **Hiratsuka-shi, Kanagawa 254-0016 (JP)**
- **ISHII Kentaro**
  **Hiratsuka-shi, Kanagawa 254-0016 (JP)**
- **YONEHAMA Shinichi**
  **Hiratsuka-shi, Kanagawa 254-0016 (JP)**

(74) Representative: **Hoffmann Eitle**
**Patent- und Rechtsanwälte PartmbB**
**Arabellastraße 30**
**81925 München (DE)**

# (54) LAMINATE

(57) Provided is a laminate including a support substrate, a polyimide resin layer on the support substrate, and an inorganic layer on the polyimide resin layer, in which a glass transition temperature of a polyimide resin constituting the polyimide resin layer is 300°C or higher, and a stress of the inorganic layer is a compressive stress. Also provided is a method for producing a laminate, the method including a step of obtaining a polyimide resin layer by applying a polyimide resin varnish or a polyimide resin precursor varnish onto a support substrate and heating, the method further including a step of depositing, on the polyimide resin layer, an inorganic layer having a compressive stress.



Processed by Luminess, 75001 PARIS (FR)

## Description

### Technical Field

The present invention relates to a laminate and a method for producing the laminate.

### Background Art

In the semiconductor field, with the progress of three-dimensional mounting technology, materials that withstand processes such as TSV formation, back surface wiring process, CVD, and hybrid bonding are required.
Known polyimide resins have excellent mechanical properties, thermal resistance, and insulating properties. Thus, various applications of polyimide resins have been studied in the fields of electric and electronic components and the like, and attempts have also been made to use polyimide resins as the insulating film.
On the other hand, a resin material such as polyimide is rarely used by itself because of concerns such as degassing due to moisture absorption or decomposition, and an inorganic layer such as SiO or SiN is used as a buffer layer or a barrier layer.
For example, Patent Document 1 discloses, for the purpose of improving colorless transparency, low residual stress, mechanical properties, thermal properties, and bending resistance, a polyimide film formed by imidizing a polyimide precursor having bis(trifluoromethyl)benzidine and a siloxane structural unit, the polyimide film having a glass transition temperature of from 150 to 380°C and an imide group concentration of from 2.00 to 3.70 mmol/g, a laminate including the polyimide film and a support, and a flexible substrate including the polyimide film and an inorganic layer.

### Citation List

### Patent Document

Patent Document 1: WO 2014/098235

### Summary of Invention

### Technical Problem

In the semiconductor field, an inorganic layer is laminated on a resin material such as polyimide as described above and used. Thus, high film-deposition properties are required for this laminate. In particular, higher thermal resistance with respect to 300°C or higher is required in CVD or hybrid bonding (Cu-Cu bonding).
In a process in which a temperature higher than the inorganic layer deposition temperature is applied after the inorganic layer deposition, defects such as cracks and peeling may occur even in a polyimide having high thermal resistance.
Thus, a laminate including a polyimide resin applicable to a high-temperature process, an inorganic layer, and a support substrate has been required.
The present invention has been made in view of such a circumstance, and an object of the present invention is to provide a laminate excellent in film-deposition properties and further excellent in thermal resistance.

### Solution to Problem

The inventors of the present invention have found that the object can be achieved by a laminate including a polyimide resin layer having a glass transition temperature of 300°C or higher on a support substrate and further including an inorganic layer in which stress is a compressive stress, and have completed the present invention.
That is, the present invention relates to the following [1] to [8].

[1] A laminate, including a support substrate, a polyimide resin layer on the support substrate, and an inorganic layer on the polyimide resin layer, wherein a glass transition temperature of a polyimide resin constituting the polyimide resin layer is 300°C or higher, and a stress of the inorganic layer is a compressive stress.
[2] The laminate according to [1], wherein the inorganic layer contains silicon.
[3] The laminate according to [1] or [2], wherein the inorganic layer includes a silicon oxide or a silicon nitride.
[4] The laminate according to any one of [1] to [3], wherein a film thickness of the polyimide resin layer is from 0.5 to 300 μm.
[5] The laminate according to any one of [1] to [4], wherein a thickness of the inorganic layer is from 1 to 1,000 nm.

[6] The laminate according to any one of [1] to [5], wherein the support substrate contains silicon.

[7] The laminate according to any one of [1] to [6], wherein the support substrate includes silicon, silicon carbide, gallium nitride, gallium oxide, aluminum nitride, or diamond.

[8] A method for producing a laminate, the method including a step of obtaining a polyimide resin layer by applying a polyimide resin varnish or a polyimide resin precursor varnish onto a support substrate and heating, the method further including a step of depositing, on the polyimide resin layer, an inorganic layer having a compressive stress.

## Advantageous Effects of Invention

According to the present invention, it is possible to provide a laminate having excellent film-deposition properties and further excellent thermal resistance. The laminate of the present invention has the properties as described above and is therefore useful as a laminate in the semiconductor process. That is, the laminate of the present invention is useful as a laminate for semiconductor memories, laminating LSIs, CMOS image sensors, MEMS sealing, optical devices, LED applications, and the like.

## Description of Embodiments

### [Laminate]

A laminate of the present invention is a laminate including a support substrate, a polyimide resin layer on the support substrate, and an inorganic layer on the polyimide resin layer, wherein a glass transition temperature of a polyimide resin constituting the polyimide resin layer is 300°C or higher, and a stress of the inorganic layer is a compressive stress.

### <Support substrate>

The laminate of the present invention has a support substrate.

The support substrate is preferably silicon, silicon carbide, gallium nitride, gallium oxide, aluminum nitride, or diamond, and more preferably silicon.

When the support substrate is made of silicon, in particular, excellent film-deposition properties and thermal resistance are obtained, which are effects of the laminate of the present invention. Further, silicon is excellent as the support substrate in the present invention because it is also excellent in yield in a crystal formation process and availability of raw materials.

The thickness of the support substrate is preferably from 1 μm to 1 mm, more preferably from 2 μm to 900 μm, still more preferably from 10 to 800 μm, even more preferably from 100 to 700 μm. When a plurality of support substrates are included, the thickness is the thickness of each support substrate, and the thicknesses of the plurality of support substrates may be the same or different.

The shape of the support substrate is not particularly limited. For example, when the support substrate is a silicon substrate, the support substrate may be a silicon substrate on which an interlayer insulating layer (Low-k film) is formed.

Examples of the interlayer insulating layer include a silicon oxide film and a silicon nitride film, and a silicon nitride film is preferable.

### <Polyimide resin layer and polyimide resin>

The laminate of the present invention includes a polyimide resin layer on the support substrate.

The polyimide resin constituting the polyimide resin layer has a glass transition temperature of 300°C or higher.

The film thickness of the polyimide resin layer is preferably from 0.5 to 300 μm, more preferably from 1 to 100 μm, still more preferably from 1 to 50 μm, even more preferably from 1 to 30 μm, even more preferably from 5 to 20 μm.

The glass transition temperature of the polyimide resin is 300°C or higher. The glass transition temperature of the polyimide resin is preferably 350°C or higher, more preferably 380°C or higher, still more preferably 400°C or higher, even more preferably 420°C or higher, even more preferably 430°C or higher, even more preferably 440°C or higher. The upper limit is not limited, but is preferably 550°C or lower. When the glass transition temperature of the polyimide resin is within the range, the laminate of the present invention is excellent in thermal resistance, and is useful as a laminate in the semiconductor process.

The structure of the polyimide resin constituting the polyimide resin layer is not limited as long as the polyimide resin has a glass transition temperature of 300°C or higher, but the polyimide resin preferably has a structural unit of General Formula (1) set forth below.

[Chem. 1]

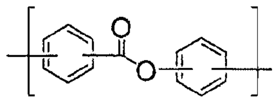 (1)

The polyimide resin preferably has a structural unit of Formula (1), more preferably has at least one structural unit selected from the group consisting of a structural unit of Formula (1a) set forth below and a structural unit of Formula (1b) set forth below, still more preferably has a structural unit of Formula (1b) set forth below.

[Chem. 2]

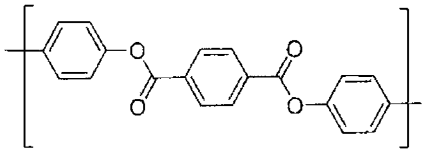 (1a) 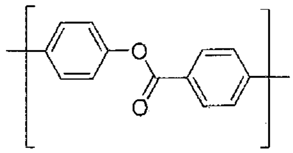 (1b)

The polyimide resin having the structural unit of Formula (1a) still more preferably includes at least one selected from the group consisting of a repeating unit represented by Formula (2a) set forth below and a repeating unit represented by Formula (3a) set forth below, even more preferably includes a repeating unit represented by Formula (2a) set forth below, even more preferably includes a repeating unit represented by Formula (2a) set forth below and a repeating unit represented by Formula (3a) set forth below.

[Chem. 3]

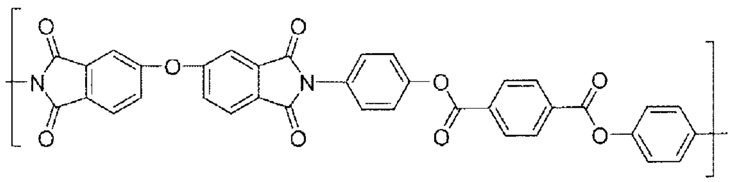 (2a)

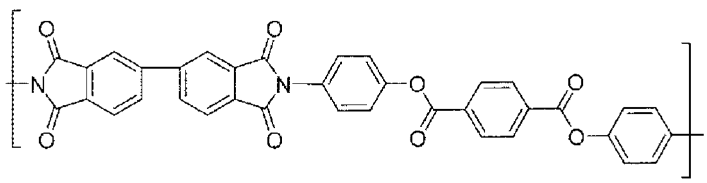 (3a)

The "repeating unit" in the polyimide resin is an imide unit including a structural unit derived from one tetracarboxylic dianhydride and a structural unit derived from one diamine.

The proportion of the repeating unit represented by Formula (2a) to the total of the repeating unit represented by Formula (2a) and the repeating unit represented by Formula (3a) is preferably from 30 to 100 mol%, and from the viewpoint of transparency, it is more preferably from 40 to 100 mol%, still more preferably from 50 to 100 mol%, even more preferably from 60 to 100 mol%, even more preferably from 70 to 100 mol%, even more preferably from 80 to 100 mol%, even more preferably 90 to 100 mol%, and it may be 100 mol%. It is more preferably from 30 to 90 mol%, still more preferably from 30 to 80 mol%, even more preferably from 30 to 70 mol%, even more preferably from 30 to 60 mol%, even more preferably from 30 to 50 mol%, from the viewpoints of thermal resistance and strength.

From the viewpoints of thermal resistance and mechanical strength, the total of the repeating unit represented by Formula (2a) and the repeating unit represented by Formula (3a) is preferably 50 mol% or more and 100 mol% or less, more preferably 70 mol% or more and 100 mol% or less, with respect to all the repeating units of the polyimide resin. It is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and mechanical strength.

The repeating unit represented by Formula (2a) is preferably 40 mol% or more, more preferably 50 mol% or more, still more preferably 60 mol% or more, even more preferably 70 mol% or more, even more preferably 80 mol% or more, even more preferably 90 mol% or more, with respect to all the repeating units of the polyimide resin from the viewpoint of

transparency. The upper limit is 100 mol% or less.

The polyimide resin may include a repeating unit other than the repeating unit represented by Formula (2a) and the repeating unit represented by General Formula (3a).

The content of the repeating unit other than the repeating unit represented by Formula (2a) and the repeating unit represented by General Formula (3a) is preferably 50 mol% or lower, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin, and it is more preferable that no repeating unit other than the repeating unit represented by Formula (2a) or the repeating unit represented by General Formula (3a) is included.

The polyimide resin having the structural unit of Formula (1b) more preferably includes a repeating unit represented by Formula (2b) set forth below.

[Chem. 4]

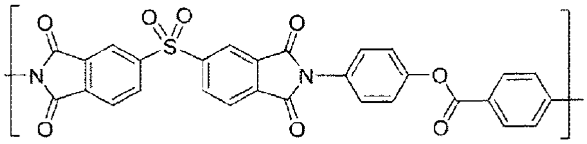
(2b)

From the viewpoints of thermal resistance and mechanical strength, the repeating unit represented by Formula (2b) is preferably 50 mol% or more and 100 mol% or less, more preferably 70 mol% or more and 100 mol% or less, with respect to all the repeating units of the polyimide resin. The repeating unit is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and adhesion.

The polyimide resin may include a repeating unit other than the repeating unit represented by Formula (2b).

The content of the repeating unit other than the repeating unit represented by Formula (2b) is preferably 50 mol% or less, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin, and it is more preferable that no repeating unit other than the repeating unit represented by Formula (2b) is included.

As described above, the polyimide resin even more preferably includes at least one selected from the group consisting of a repeating unit represented by Formula (2a), a repeating unit represented by Formula (3a), and a repeating unit represented by Formula (2b), even more preferably includes a repeating unit represented by Formula (2b). The inclusion of the repeating unit represented by Formula (2b) is preferable because the polyimide resin can be dissolved in any solvents, particularly in ester solvents, when varnishes are prepared.

<Structural units of polyimide resin>

The polyimide resin has a structural unit A derived from a tetracarboxylic dianhydride and a structural unit B derived from a diamine.

In the polyimide resin, the structural unit A and the structural unit B form an imide structure.

The structural unit A preferably includes at least one selected from the group consisting of a structural unit (A1) derived from a compound represented by Formula (a1) described below, a structural unit (A2) derived from a compound represented by Formula (a2) described below, and a structural unit (A3) derived from a compound represented by Formula (a3) described below. The structural unit B preferably includes at least one selected from the group consisting of a structural unit (B1) derived from a compound represented by Formula (b1) described below, a structural unit (B2) derived from a compound represented by Formula (b2) described below, and a structural unit (B3) derived from a compound represented by Formula (b3) described below.

[Chem. 5]

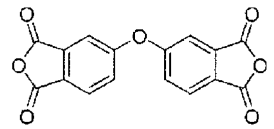 (a1)

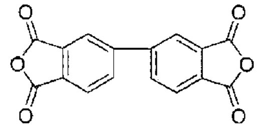 (a2)

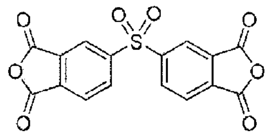 (a3)

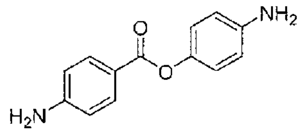 (b1)

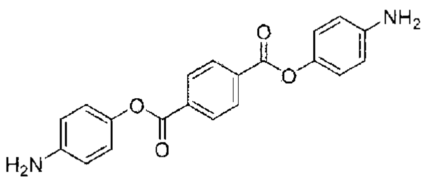 (b2)

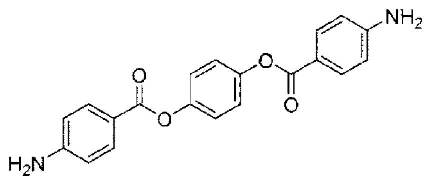 (b3)

(Structural unit A)

The structural unit A is a structural unit derived from a tetracarboxylic dianhydride, preferably includes at least one selected from the group consisting of a structural unit (A1) derived from a compound represented by Formula (a1), a structural unit (A2) derived from a compound represented by Formula (a2), and a structural unit (A3) derived from a compound represented by Formula (a3), more preferably includes a structural unit (A3) derived from a compound represented by Formula (a3). When the structural unit A includes the structural unit (A1) derived from the compound represented by Formula (a1), the structural unit A even more preferably includes the structural unit (A1) derived from the compound represented by Formula (a1) and the structural unit (A2) derived from the compound represented by Formula (a2).

The compound represented by Formula (a1) is 4,4'-oxydiphthalic anhydride (ODPA). By using the structural unit (A1) derived from the compound represented by Formula (a1) as a structural unit of the polyimide resin, excellent thermal resistance and strength is obtained in the polyimide resin.

The compound represented by Formula (a2) is 3,3',4,4'-biphenyltetracarboxylic dianhydride (s-BPDA). By using the structural unit (A2) derived from the compound represented by Formula (a2) as a structural unit of the polyimide resin, thermal resistance and strength can be further enhanced.

The compound represented by Formula (a3) is 3,3',4,4'-diphenylsulfonetetracarboxylic dianhydride (DSDA). By using the structural unit (A3) derived from the compound represented by Formula (a3) as a structural unit of the polyimide resin, thermal resistance and adhesion can be further enhanced.

The total of the proportion of the structural unit (A1), the proportion of the structural unit (A2), and the proportion of the structural unit (A3) in the structural unit A is preferably 50 mol% or more and 100 mol% or less. It is more preferably 70 mol% or more and 100 mol% or less, still more preferably 80 mol% or more and 100 mol% or less, still more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and mechanical strength.

When the structural unit A includes the structural unit (A1) and the structural unit (A2), the proportion of the total of the structural unit (A1) and the structural unit (A2) in the structural unit A is preferably 50 mol% or more and 100 mol% or less, more preferably 70 mol% or more and 100 mol% or less. It is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and mechanical strength.

The proportion of the structural unit (A1) to the total of the structural unit (A1) and the structural unit (A2) is preferably from 30 to 100 mol%, and from the viewpoints of thermal resistance, strength, and transparency, it is more preferably from 40 to 100 mol%, still more preferably from 50 to 100 mol%, even more preferably from 60 to 100 mol%, even more preferably from 70 to 100 mol%, even more preferably from 80 to 100 mol%, even more preferably 90 to 100 mol%, and it may be 100 mol%. It is more preferably from 30 to 90 mol%, still more preferably from 30 to 80 mol%, even more

preferably from 30 to 70 mol%, even more preferably from 30 to 60 mol%, even more preferably from 30 to 50 mol%, from the viewpoints of thermal resistance and strength.

The proportion of the structural unit (A1) in the structural unit A is preferably 40 mol% or more, more preferably 50 mol% or more, still more preferably 60 mol% or more, even more preferably 70 mol% or more, even more preferably 80 mol% or more, even more preferably 90 mol% or more, from the viewpoints of thermal resistance, strength, and transparency. The upper limit is 100 mol% or less.

When the structural unit A includes the structural unit (A3), the proportion of the structural unit (A3) in the structural unit A is preferably 50 mol% or more and 100 mol% or less. The proportion is more preferably 70 mol% or more and 100 mol% or less, still more preferably 80 mol% or more and 100 mol% or less, still more preferably 90 mol% or more and 100 mol% or less, even more preferably 95 mol% or more and 100 mol% or less, even more preferably 99 mol% or more and 100 mol% or less, and it may be 100 mol%. It is even more preferably 100 mol% from the viewpoints of thermal resistance and adhesion.

The structural unit A may include a structural unit other than the structural unit (A1), the structural unit (A2), and the structural unit (A3). Such a structural unit is not particularly limited, and examples thereof include a structural unit derived from an aromatic tetracarboxylic dianhydride, a structural unit derived from an alicyclic tetracarboxylic dianhydride, and a structural unit derived from an aliphatic tetracarboxylic dianhydride, other than the structural unit (A1), the structural unit (A2), and the structural unit (A3).

Examples of the aromatic tetracarboxylic dianhydride that provides a structural unit derived from the aromatic tetracarboxylic dianhydride other than the structural unit (A1), the structural unit (A2), and the structural unit (A3) include pyromellitic dianhydride (PMDA), 3,3',4,4'-benzophenone tetracarboxylic dianhydride (BTDA), 9,9-bis(trifluoromethyl)-9H-xanthene-2,3,6,7-tetracarboxylic dianhydride (6FCDA), 2,2-bis[4-(3,4-dicarboxyphenoxy)phenyl]hexafluoropropane dianhydride, 2,3,3',4'-biphenyltetracarboxylic dianhydride (a-BPDA), 9,9'-bis(3,4-dicarboxyphenyl)fluorene dianhydride (BPAF), hydroquinone diphthalic anhydride (HQDEA), ethylene glycol bis(trimellitate)dianhydride (TMEG), p-phenylene bis(trimellitate)dianhydride (TAHQ), 4,4'-(hexafluoroisopropylidene)diphthalic anhydride (6FDA), 2,2',3,3',5,5'-hexamethyl[1,1'-biphenyl]-4,4'-diyl=bis(1,3-dioxo-1,3-dihydro-2-benzofuran-5-carboxylate) (TMPBP-TME), 2,2-bis(3,4-dicarboxyphenyl)-propane dianhydride, spiro[11H-difuro[3,4-b:3',4'-i]xanthene-11,9'-[9H]fluorene]-1,3,7,9-tetrone (SFDA), 4,4'-thiodiphthalic anhydride, 5-[4-(1,3-dioxo-2-benzofuran-5-yl)phenyl]-2-benzofuran-1,3-dione, 5-[3-(1,3-dioxo-2-benzofuran-5-yl)phenyl]-2-benzofuran-1,3-dione, and p-biphenylene bis(trimellitic acid monoester acid anhydride) (BP-TME).

Among these, pyromellitic dianhydride (PMDA) is preferable. When the structural unit A has a structural unit derived from PMDA, a laminate having adhesion, step embedding properties, flatness, and thermal resistance is obtained.

Examples of the alicyclic tetracarboxylic dianhydride that provides a structural unit derived from the alicyclic tetracarboxylic dianhydride include cyclohexane-1,2,4,5-tetracarboxylic dianhydride (HPMDA), cyclohexane-1,2,3,4-tetracarboxylic dianhydride, 1,2,3,4-cyclobutanetetracarboxylic dianhydride, 1,2,3,4-cyclopentanetetracarboxylic dianhydride, 1,2,4,5-cyclopentanetetracarboxylic dianhydride, 3,3',4,4'-bicyclohexyltetracarboxylic dianhydride, 1,2,3,4-tetramethyl-1,2,3,4-cyclobutanetetracarboxylic dianhydride, decahydro-1,4:5,8-dimethanonaphthalene-2,3,6,7-tetracarboxylic dianhydride (DNDA), 5,5'-(1,4-phenylene)-bis[hexahydro-4,7-Methanoisobenzofuran-1,3-dione], 5,5'-bis-2-norbornene-5,5',6,6'-tetracarboxylic acid-5,5',6,6'-dianhydride, norbornane-2-spiro-$\alpha$-cyclopentanone-$\alpha$'-spiro-2''-norbornane-5,5',6,6'-tetracarboxylic acid dianhydride (CpODA), 2,2-propylidene-4,4'-bis(cyclohexane-1,2-dicarboxylic acid)dianhydride, oxy-4,4'-bis(cyclohexane-1,2-dicarboxylic acid)dianhydride, bicyclo[2.2.2]oct-7-ene-2,3,5,6-tetracarboxylic dianhydride, bicyclo[2.2.2]octane-2,3:5,6-tetracarboxylic dianhydride (BODA), and bicyclo[4.4.0]decane-2,3,6,7-tetracarboxylic dianhydride.

Examples of the aliphatic tetracarboxylic dianhydride that provides a structural unit derived from an aliphatic tetracarboxylic dianhydride include 1,2,3,4-butanetetracarboxylic dianhydride.

The structural unit optionally included in the structural unit A may be of one type or two or more types.

In the present specification, the term "aromatic tetracarboxylic dianhydride" refers to a tetracarboxylic dianhydride including one or more aromatic rings, the term "alicyclic tetracarboxylic dianhydride" refers to a tetracarboxylic dianhydride including one or more alicyclic rings and including no aromatic ring, and "aliphatic tetracarboxylic dianhydride" refers to a tetracarboxylic dianhydride including no aromatic ring and no alicyclic ring.

(Structural unit B)

The structural unit B is a structural unit derived from a diamine, and it preferably includes at least one selected from the group consisting of a structural unit (B1) derived from a compound represented by Formula (b1), a structural unit (B2) derived from a compound represented by Formula (b2), and a structural unit (B3) derived from a compound represented by Formula (b3), more preferably includes at least one selected from the group consisting of a structural unit (B1) derived from a compound represented by Formula (b1) and a structural unit (B2) derived from a compound represented by Formula (b2), still more preferably includes a structural unit (B1) derived from a compound represented

by Formula (b1).

The compound represented by Formula (b1) is 4-aminophenyl-4-aminobenzoate (4-BAAB). When the structural unit B includes the structural unit (B1), the thermal resistance of the resulting polyimide resin is excellent, and the adhesion can also be improved.

The compound represented by Formula (b2) is bis(4-aminophenyl)terephthalate (APTP). When the structural unit B includes the structural unit (B2), the thermal resistance of the resulting polyimide resin is excellent, and the adhesion of the polyimide resin can also be improved.

The compound represented by Formula (b3) is 1,4-bis(4-aminobenzoyloxy)benzene. When the structural unit B includes the structural unit (B3), the thermal resistance of the resulting polyimide resin is excellent, and the adhesion of the polyimide resin can also be improved.

The total of the proportion of the structural unit (B1), the proportion of the structural unit (B2), and the proportion of the structural unit (B3) in the structural unit B is preferably from 30 to 100 mol%, more preferably from 70 to 100 mol%, still more preferably from 90 to 100 mol%, even more preferably from 95 to 100 mol%, and it may be 100 mol%, and the structural unit B may include only at least one selected from the group consisting of the structural unit (B1), the structural unit (B2), and the structural unit (B3).

The proportion of the structural unit (B1) in the structural unit B is preferably from 30 to 100 mol%, more preferably from 70 to 100 mol%, still more preferably from 90 to 100 mol%, even more preferably from 95 to 100 mol%, and it may be 100 mol%. The structural unit B may include only the structural unit (B1).

The proportion of the structural unit (B2) in the structural unit B is preferably from 30 to 100 mol%, more preferably from 70 to 100 mol%, still more preferably from 90 to 100 mol%, even more preferably from 95 to 100 mol%, and it may be 100 mol%. The structural unit B may include only the structural unit (B2).

The proportion of the structural unit (B3) in the structural unit B is preferably from 30 to 100 mol%, more preferably from 70 to 100 mol%, still more preferably from 90 to 100 mol%, even more preferably from 95 to 100 mol%, and it may be 100 mol%. The structural unit B may include only the structural unit (B3).

When the proportions of the structural unit (B1), the structural unit (B2), and the structural unit (B3) are within the above ranges, the thermal resistance of the resulting polyimide resin is excellent, and the application properties of the varnish and the adhesion of the polyimide resin can also be improved.

The structural unit B may include a structural unit other than the structural unit (B1), the structural unit (B2), and the structural unit (B3). The diamine that provides such a structural unit is not particularly limited, and examples thereof include aromatic diamines, alicyclic diamines, and aliphatic diamines excluding any of the compound represented by Formula (b1), the compound represented by Formula (b2), and the compound represented by Formula (b3).

Examples of the aromatic diamine include 2,2'-bis(trifluoromethyl)-4,4'-diaminodiphenyl ether (6FODA), 2,2'-bis(trifluoromethyl)-4,4'-diaminobiphenyl (2,2'-TFMB), 3,3'-bis(trifluoromethyl)-4,4'-diaminobiphenyl, 2,2'-bis(trifluoromethyl)-5,5'-diaminobiphenyl, 2,2-bis(4-aminophenyl)hexafluoropropane (HFDA), 2,2-bis(3-amino-4-methylphenyl) hexafluoropropane, 2,2-bis[4-(4-aminophenoxy)phenyl]hexafluoropropane (HFBAPP), 4,4'-diaminodiphenyl ether (4,4'-ODA), 3,4'-diaminodiphenyl ether, 4,4'-diaminodiphenyl methane (DDM), 4,4'-diaminodiphenyl sulfone (4,4'-DDS), 3,3'-diaminodiphenyl sulfone (3,3'-DDS), 4,4'-diamino-2,2'-dimethylbiphenyl (mTB), 9,9-bis(4-aminophenyl)fluorene (BAFL), 4,4'-diaminobiphenyl (benzidine), 4,4'-diamino-3,3'-dimethylbiphenyl, 4,4'-diaminodiphenyl sulfide, 4,4'-diaminobenzophenone, 2,2-bis(3-aminophenyl)propane, 2,2-bis(4-aminophenyl)propane, 5-amino-1,3,3-trimethyl-1-(4-aminophenyl)-indane (5-TMDM), 6-amino-1,3,3-trimethyl-1-(4-aminophenyl)-indane (6-TMDM), 1,3-bis(3-amino-α,α-dimethylbenzyl)benzene, 1,3-bis(4-amino-α,α-dimethylbenzyl)benzene (BisAM), 1,4-bis(4-amino-α,α-dimethylbenzyl) benzene (BisAP), 4,4'-bis(3-aminophenoxy)biphenyl, 4,4'-bis(4-aminophenoxy)biphenyl (BODA), 1,1-bis[4-(4-aminophenoxy)phenyl]cyclohexane, 2,2-bis[4-(4-aminophenoxy)phenyl]propane (BAPP), 1,4-bis(3-aminophenoxy)benzene, 1,4-bis(4-aminophenoxy)benzene, 1,3-bis(3-aminophenoxy)benzene, 1,3-bis(4-aminophenoxy)benzene, bis[4-(3-aminophenoxy)phenyl]ketone, bis[4-(4-aminophenoxy)phenyl]ketone, bis[4-(3-aminophenoxy)phenyl]sulfide, bis[4-(4-aminophenoxy)phenyl]sulfide, bis[4-(3-aminophenoxy)phenyl]ether, bis[4-(4-aminophenoxy)phenyl]ether, bis[4-(3-aminophenoxy)phenyl]sulfone, bis[4-(4-aminophenoxy)phenyl]sulfone, 4,4-diaminobenzanilide, 4-aminobenzoic acid-4-aminophenyl, and 3,4-diaminobenzanilide.

Examples of the alicyclic diamine include 1,3-bis(aminomethyl)cyclohexane (1,3-BAC), 1,4-bis(aminomethyl) cyclohexane, 1,3-cyclohexyldiamine, 1,4-cyclohexyldiamine, isophorone diamine, bis(aminomethyl)norbornane, 4,4'-diaminodicyclohexylmethane, 4,4'-diaminodicyclohexyl ether, and 2,2-bis(4-aminocyclohexyl)propane.

Examples of the aliphatic diamine include ethylenediamine and hexamethylenediamine.

In the present specification, the term "aromatic diamine" refers to a diamine including one or more aromatic rings, the term "alicyclic diamine" refers to a diamine including one or more alicyclic rings and including no aromatic ring, and the term "aliphatic diamine" refers to a diamine including no aromatic ring and no alicyclic ring.

The structural unit optionally included in the structural unit B, other than the structural unit (B1), the structural unit (B2), and the structural unit (B3) may be of one type or two or more types.

The polyimide resin may have a structure other than a polyimide chain (structure in which the structural unit A and

the structural unit B are imide-bonded) as long as the present invention is not impaired. As the structure, other than the polyimide chain, that can be contained in the polyimide resin, examples thereof include a structure containing an amide bond.

The polyimide resin preferably contains a polyimide chain (structure in which the structural unit A and the structural unit B are imide-bonded) as a main structure. Thus, the proportion of the polyimide chain in the polyimide resin is preferably 80 mass% or more, more preferably 90 mass% or more, still more preferably 99 mass% or more, even more preferably 100 mass%.

[Method for producing polyimide resin]

The polyimide resin may be produced by any methods, but is preferably produced by the following methods.

The polyimide resin may be obtained directly by polymerizing a diamine (hereinafter, also referred to as a diamine component) and a tetracarboxylic dianhydride (hereinafter, also referred to as a tetracarboxylic acid component), or may be obtained by polymerizing a diamine and a tetracarboxylic dianhydride to obtain a polyamic acid or an imide-amic acid copolymer, which is a precursor of a polyimide resin (polyimide resin precursor), and imidizing the polyamic acid or the imide-amic acid copolymer at the time of producing a laminate. In particular, a method in which a polyimide resin precursor is obtained and imidized at the time of producing a laminate is preferable.

Here, an imide-amic acid copolymer as a polyimide resin precursor, a method for producing a polyamic acid, and a method for producing a polyimide resin for directly obtaining a polyimide resin will be described. The polyimide resin precursor and the polyimide resin may be collectively referred to as a polymer.

(Method for producing imide-amic acid copolymer as polyimide resin precursor)

A preferable production method in the case of a polymer containing both an imide unit and an amic acid unit (hereinafter, also referred to as an imide-amic acid copolymer) includes the following Step 1 and the following Step 2.

Step 1: a step of causing a tetracarboxylic dianhydride and a diamine to react in the presence of a solvent to obtain an imide oligomer.

Step 2: a step of mixing and polymerizing the imide oligomer obtained in Step 1 and at least either a tetracarboxylic dianhydride or a diamine.

[Step 1]

Step 1 is a step of causing a tetracarboxylic dianhydride and a diamine to react in the presence of a solvent to obtain an imide oligomer. The tetracarboxylic dianhydride and the diamine constitute an imide moiety.

In Step 1, the amount of the diamine with respect to the tetracarboxylic dianhydride is preferably from 1.01 to 2 mol, more preferably from 1.05 to 1.9 mol, still more preferably from 1.1 to 1.7 mol.

The method for causing a tetracarboxylic dianhydride and a diamine to react to obtain an imide oligomer in Step 1 is not particularly limited, and a known method can be used.

Specific examples of the reaction method include (1) a method in which a tetracarboxylic dianhydride, a diamine, and a solvent are fed into a reactor, this mixture is stirred at a temperature from 10 to 110°C for a period of time ranging from 0.5 to 30 hours, followed by increasing the temperature to perform an imidization reaction, (2) a method in which a diamine and a solvent are fed into a reactor and dissolved, then a tetracarboxylic dianhydride is added thereto, this mixture is stirred at room temperature of from 10 to 110°C for a period of time ranging from 0.5 to 30 hours as necessary, followed by increasing the temperature to perform an imidization reaction, and (3) a method in which a tetracarboxylic dianhydride, a diamine, and a solvent are fed into a reactor, and then immediately increasing the temperature to perform an imidization reaction.

In the imidization reaction, the reaction is preferably performed with a Dean-Stark apparatus or the like to remove water produced during the production. By performing such operation, the degree of polymerization and the degree of imidization can be further increased.

In the imidization reaction described above, a known imidization catalyst can be used. As the imidization catalyst, a base catalyst or an acid catalyst can be exemplified.

Examples of the base catalyst include: organic base catalysts such as pyridine, quinoline, isoquinoline, α-picoline, β-picoline, 2,4-lutidine, 2,6-lutidine, trimethylamine, triethylamine, tripropylamine, tributylamine, triethylenediamine, imidazole, N,N-dimethylaniline, and N,N-diethylaniline; and inorganic base catalysts such as potassium hydroxide, sodium hydroxide, potassium carbonate, sodium carbonate, potassium hydrogen carbonate, and sodium hydrogen carbonate.

Examples of the acid catalyst include crotonic acid, acrylic acid, trans-3-hexenoic acid, cinnamic acid, benzoic acid, methylbenzoic acid, oxybenzoic acid, terephthalic acid, benzenesulfonic acid, p-toluenesulfonic acid, and naphthalenesulfonic acid. The imidization catalysts described above may be used alone, or two or more types thereof may be used in combination.

Among the catalysts described above, from the viewpoint of handleability, a base catalyst is preferable, an organic base catalyst is more preferable, one or more selected from the group consisting of triethylamine and triethylenediamine is still more preferable, and triethylamine is even more preferable.

The temperature for the imidization reaction is preferably in a range from 120 to 250°C, and more preferably from 160 to 200°C, from the viewpoints of reaction rate and suppression of gelling or the like. The reaction time is preferably from 0.5 to 10 hours after the start of distillation of produced water.

Through the method described above, a solution containing the imide oligomer dissolved in the solvent is obtained. The solution containing the imide oligomer obtained in Step 1 may contain at least a part of the components used as the tetracarboxylic dianhydride or the diamine in Step 1 as an unreacted monomer as long as the effect of the present invention is not impaired.

[Step 2]

Step 2 is a step of mixing and polymerizing the imide oligomer obtained in Step 1 and at least either a tetracarboxylic dianhydride or a diamine.

The amount of the diamine component with respect to the tetracarboxylic acid component in all of Step 1 and Step 2 is preferably from 0.9 to 1.1 mol.

In Step 2, the method for polymerizing the imide oligomer obtained in Step 1, a tetracarboxylic dianhydride, and a diamine is not particularly limited, and a known method can be used.

Specific examples of the reaction method include (1) a method in which an imide oligomer and at least either a tetracarboxylic dianhydride or a diamine are fed into a reactor and stirred at a temperature in the range of from 0 to 120°C, preferably from 5 to 80°C for a period of time ranging from 1 to 72 hours, and (2) a method in which the imide oligomer and a solvent are fed into a reactor and dissolved, and then at least either a tetracarboxylic dianhydride or a diamine is fed and stirred at a temperature in the range of from 0 to 120°C, preferably from 5 to 80°C for a period of time ranging from 1 to 72 hours.

When the reaction is performed at 80°C or lower, the molecular weight of the copolymer obtained in Step 2 does not vary depending on the temperature history at the time of polymerization, and the progress of thermal imidization can also be suppressed. Thus, the copolymer can be stably produced.

The concentration of the copolymer in the resulting solution is preferably from 1 to 50 mass%, more preferably from 3 to 35 mass%, still more preferably from 5 to 30 mass%.

(Method for producing polyamic acid as polyimide resin precursor)

A preferable method for producing a polyimide resin precursor when the polyimide resin precursor is a polyamic acid is a method in which a tetracarboxylic dianhydride and a diamine are caused to react in the presence of a solvent to obtain a polyamic acid.

The method for polymerizing a tetracarboxylic dianhydride and a diamine is not particularly limited, and a known method can be used.

Specific examples of the reaction method include a method in which a solution containing a diamine and a solvent and a tetracarboxylic dianhydride are fed into a reactor and stirred at a temperature in the range of preferably from 0 to 120°C, more preferably from 5 to 80°C for a period of time ranging from 1 to 72 hours.

The diamine component with respect to the tetracarboxylic acid component is preferably from 0.9 to 1.1 mol.

When performing the reaction at 80°C or lower, the molecular weight of the polyamic acid does not vary depending on the temperature history during polymerization, and the progress of thermal imidization can also be suppressed. Thus, the polyamic acid can be stably produced.

The concentration of the polyamic acid in the resulting solution is preferably from 1 to 50 mass%, more preferably from 3 to 35 mass%, still more preferably from 5 to 30 mass%.

(Method for producing polyimide resin)

A preferable production method in the case of directly obtaining a polyimide resin is a method in which a tetracarboxylic dianhydride and a diamine are caused to react in the presence of a solvent to obtain a polyimide resin.

The method for polymerizing a tetracarboxylic dianhydride and a diamine is not particularly limited, and a known method can be used.

Specific examples of the reaction method include (1) a method in which a solution containing a diamine and a solvent and a tetracarboxylic dianhydride are fed into a reactor, stirred at from 10 to 110°C for a period of time ranging from

0.5 to 30 hours as necessary, and then heated to perform an imidization reaction, and (2) a method in which a solution containing a diamine and a solvent and a tetracarboxylic dianhydride are fed into a reactor, and immediately heated to perform an imidization reaction.

In the imidization reaction, the reaction is preferably performed with a Dean-Stark apparatus or the like to remove water produced during the production. By performing such operation, the degree of polymerization and the degree of imidization can be further increased.

In the imidization reaction described above, a known imidization catalyst can be used. As the imidization catalyst, a base catalyst or an acid catalyst can be exemplified.

Examples of the base catalyst include: organic base catalysts such as pyridine, quinoline, isoquinoline, α-picoline, β-picoline, 2,4-lutidine, 2,6-lutidine, trimethylamine, triethylamine, tripropylamine, tributylamine, triethylenediamine, imidazole, N,N-dimethylaniline, and N,N-diethylaniline; and inorganic base catalysts such as potassium hydroxide, sodium hydroxide, potassium carbonate, sodium carbonate, potassium hydrogen carbonate, and sodium hydrogen carbonate.

Examples of the acid catalyst include crotonic acid, acrylic acid, trans-3-hexenoic acid, cinnamic acid, benzoic acid, methylbenzoic acid, oxybenzoic acid, terephthalic acid, benzenesulfonic acid, p-toluenesulfonic acid, and naphthalenesulfonic acid. The imidization catalysts described above may be used alone, or two or more types thereof may be used in combination.

Among the catalysts described above, from the viewpoint of handleability, a base catalyst is preferable, an organic base catalyst is more preferable, one or more selected from the group consisting of triethylamine and triethylenediamine is still more preferable, and triethylamine is even more preferable.

The temperature for the imidization reaction is preferably in a range from 120 to 250°C, and more preferably from 160 to 200°C, from the viewpoints of reaction rate and suppression of gelling or the like. The reaction time is preferably from 0.5 to 10 hours after the start of distillation of produced water.

The concentration of the polyimide in the resulting solution is preferably from 1 to 50 mass%, more preferably from 3 to 35 mass%, still more preferably from 5 to 30 mass%.

Next, raw materials and the like used in the method for producing the imide-amic acid copolymer, the polyamic acid, and the polyimide resin will be described.

[Tetracarboxylic dianhydride]

The tetracarboxylic dianhydride used as a raw material in the production method is preferably the tetracarboxylic dianhydride described in the structural unit A of the polyimide resin.

Examples of the tetracarboxylic dianhydride include, but are not limited to, acid dianhydrides, and a derivative thereof may also be used as long as it is within a range of providing the structural unit A. Examples of the derivative include a tetracarboxylic acid (free acid) and an alkyl ester of the tetracarboxylic acid. Among these, acid dianhydride is preferable.

[Diamine]

The diamine used as a raw material in the production method is preferably the diamine described in the structural unit B of the polyimide resin.

Examples of the diamine include, but are not limited to, diamines, and a derivative thereof may also be used as long as it is within a range of providing the structural unit B in the polymer. Examples of the derivative include diisocyanates corresponding to the diamine. Among these, a diamine is preferable.

[End-capping agent]

Other than the tetracarboxylic acid component or the diamine component described above, an end-capping agent may also be used in the production of the polymer. The end-capping agent is preferably used in Step 2 in the production of the imide-amic acid copolymer.

As the end-capping agent, acid anhydrides, monoamines, or dicarboxylic acids are preferable. The amount of the end-capping agent to be introduced is preferably from 0.0001 to 20 mol, more preferably from 0.1 to 10 mol, still more preferably from 0.5 to 5 mol, with respect to 1 mol of the tetracarboxylic acid component. Examples of the monoamine end-capping agent to be recommended include methylamine, ethylamine, propylamine, butylamine, benzylamine, 4-methylbenzylamine, 4-ethylbenzylamine, 4-dodecylbenzylamine, 3-methylbenzylamine, 3-ethylbenzylamine, aniline, 3-methylaniline, 4-methylaniline, o-aminophenol, m-aminophenol, p-aminophenol, o-aminobenzoic acid, m-aminobenzoic acid, and p-aminobenzoic acid. Among these, benzylamine, aniline, o-aminophenol, m-aminophenol, p-aminophenol, o-aminobenzoic acid, m-aminobenzoic acid, and p-aminobenzoic acid can be suitably used. As the dicarboxylic acid end-capping agent, dicarboxylic acids are preferable, and a part thereof may be ring-closed. Recommended examples

thereof include phthalic acid, phthalic anhydride, 4-chlorophthalic acid, tetrafluorophthalic acid, 2,3-benzophenone dicarboxylic acid, 3,4-benzophenone dicarboxylic acid, cyclopentane-1,2-dicarboxylic acid, 4-cyclohexene-1,2-dicarboxylic acid, and trimellitic anhydride. Among these, phthalic acid, phthalic anhydride, and trimellitic anhydride can be suitably used.

[Solvent]

The solvent to be used in the method for producing a polymer may be any solvent that can dissolve the polymer to be produced. Examples of the solvent include aprotic solvents, phenol-based solvents, ether-based solvents, and carbonate-based solvents.

Specific examples of the aprotic solvent include amide-based solvents such as cyclic amides and chain amides, phosphorus-containing amide-based solvents, sulfur-containing solvents, ketone-based solvents, and ester-based solvents containing cyclic esters.

Among these, the solvent preferably contains at least one selected from the group consisting of a cyclic amide, a chain amide, and a cyclic ester, and more preferably contains a cyclic amide.

Examples of the cyclic amide include N-methylpyrrolidone, N-methylcaprolactam, and 1,3-dimethylimidazolidinone. N-methylpyrrolidone is preferable.

Examples of the chain amide include N,N-dimethylformamide, N,N-dimethylacetamide, and tetramethylurea.

Examples of the cyclic ester include γ-butyrolactone and γ-valerolactone.

Examples of the ester-based solvent include acetic acid(2-methoxy-1-methylethyl).

Examples of the phosphorus-containing amide-based solvent include hexamethylphosphoric amide and hexamethylphosphine triamide.

Examples of the sulfur-containing solvent include dimethyl sulfone, dimethyl sulfoxide, and sulfolane.

Examples of the ketone-based solvent include acetone, methyl ethyl ketone, cyclohexanone, and methyl cyclohexanone.

Specific examples of the phenol-based solvent include phenol, o-cresol, m-cresol, p-cresol, 2,3-xylenol, 2,4-xylenol, 2,5-xylenol, 2,6-xylenol, 3,4-xylenol, and 3,5-xylenol.

Specific examples of the ether-based solvent include 1,2-dimethoxyethane, bis(2-methoxyethyl)ether, 1,2-bis(2-methoxyethoxy)ethane, bis[2-(2-methoxyethoxy)ethyl]ether, tetrahydrofuran, and 1,4-dioxane.

Specific examples of the carbonate-based solvent include diethyl carbonate, methylethyl carbonate, ethylene carbonate, and propylene carbonate.

Among the solvents, at least one selected from the group consisting of a cyclic amide, a chain amide, and a cyclic ester is preferably included, at least one selected from the group consisting of a cyclic amide and a cyclic ester is more preferably included, and a cyclic ester is even more preferably included. More specifically, the solvent contains at least one selected from the group consisting of N-methylpyrrolidone and γ-butyrolactone, and more preferably contains γ-butyrolactone. The solvents described above may be used alone, or two or more types may be used as a mixture.

(Polyimide resin precursor)

In the method for producing a polyimide resin and the method for producing a laminate described later, the polyimide resin precursor to be used as a raw material of the polyimide resin is not limited in its structure as long as the glass transition temperature of the resulting polyimide resin is 300°C or higher as described above, but preferably, the polyimide resin precursor has a structural unit of General Formula (1) set forth below.

[Chem. 6]

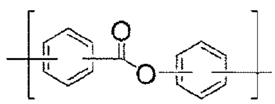 (1)

The polyimide resin precursor preferably has a structural unit of Formula (1), more preferably has at least one structural unit selected from the group consisting of a structural unit of Formula (1a) set forth below and a structural unit of Formula (1b) set forth below, still more preferably has a structural unit of Formula (1b) set forth below.

[Chem. 7]

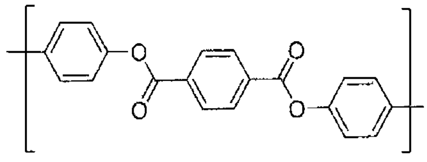 (1a) 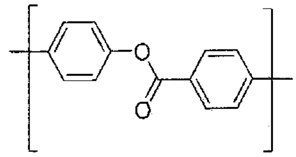 (1b)

The polyimide resin precursor having the structural unit of Formula (1a) still more preferably includes at least one selected from the group consisting of a repeating unit represented by Formula (4a) set forth below and a repeating unit represented by Formula (5a) set forth below, even more preferably includes a repeating unit represented by Formula (4a) set forth below, even more preferably includes a repeating unit represented by Formula (4a) set forth below and a repeating unit represented by Formula (5a) set forth below.

[Chem. 8]

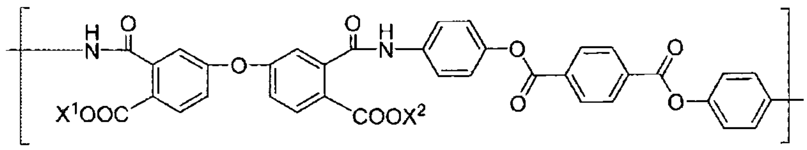 (4a)

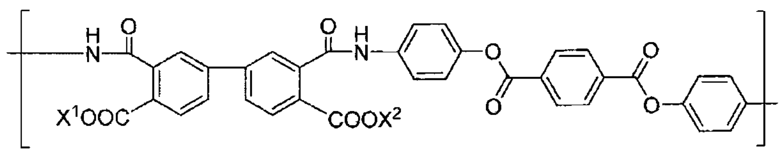 (5a)

(In Formula (4a) and Formula (5a), $X^1$ and $X^2$ are each independently a hydrogen atom, an alkyl group having from 1 to 6 carbon atoms, or an alkylsilyl group having from 3 to 9 carbon atoms.)

The "repeating unit" in the polyimide resin precursor is an amic acid unit including a structural unit derived from one tetracarboxylic dianhydride and a structural unit derived from one diamine.

In Formula (4a) and Formula (5a), $X^1$ and $X^2$ are each independently at least one selected from the group consisting of a hydrogen atom, an alkyl group having from 1 to 6 carbon atoms, and an alkylsilyl group having from 3 to 9 carbon atoms, preferably at least one selected from the group consisting of a hydrogen atom and an alkyl group having from 1 to 6 carbon atoms, more preferably a hydrogen atom.

The proportion of the repeating unit represented by Formula (4a) to the total of the repeating unit represented by Formula (4a) and the repeating unit represented by Formula (5a) is preferably from 30 to 100 mol%, and from the viewpoint of transparency, it is more preferably from 40 to 100 mol%, still more preferably from 50 to 100 mol%, even more preferably from 60 to 100 mol%, even more preferably from 70 to 100 mol%, even more preferably from 80 to 100 mol%, even more preferably 90 to 100 mol%, and it may be 100 mol%. The proportion is more preferably from 30 to 90 mol%, still more preferably from 30 to 80 mol%, even more preferably from 30 to 70 mol%, even more preferably from 30 to 60 mol%, even more preferably from 30 to 50 mol%, from the viewpoints of thermal resistance and strength.

From the viewpoints of thermal resistance and mechanical strength, the total of the repeating unit represented by Formula (4a) and the repeating unit represented by Formula (5a) is preferably 50 mol% or more and 100 mol% or less, more preferably 70 mol% or more and 100 mol% or less, with respect to all the repeating units of the polyimide resin precursor. The total is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. The total is even more preferably 100 mol% from the viewpoints of thermal resistance and mechanical strength.

The repeating unit represented by Formula (4a) is preferably 40 mol% or more, more preferably 50 mol% or more, still more preferably 60 mol% or more, even more preferably 70 mol% or more, even more preferably 80 mol% or more, even more preferably 90 mol% or more, with respect to all the repeating units of the polyimide resin precursor from the viewpoint of transparency. The upper limit is 100 mol% or less.

The polyimide resin precursor may include a repeating unit other than the repeating unit represented by Formula (4a) and the repeating unit represented by General Formula (5a).

The content of the repeating unit other than the repeating unit represented by Formula (4a) or the repeating unit represented by General Formula (5a) is preferably 50 mol% or less, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin precursor, and it is even

more preferable that no repeating unit other than the repeating unit represented by Formula (4a) and the repeating unit represented by General Formula (5a) is included.

The polyimide resin precursor having the structural unit of Formula (1b) preferably includes a repeating unit represented by Formula (4b) set forth below.

[Chem. 9]

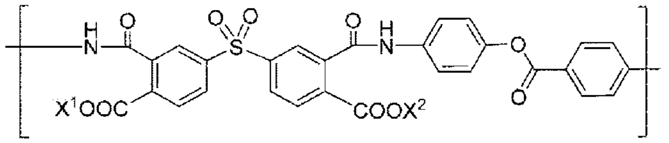

(4b)

(In Formula (4b), $X^1$ and $X^2$ are each independently a hydrogen atom, an alkyl group having from 1 to 6 carbon atoms, or an alkylsilyl group having from 3 to 9 carbon atoms.)

In Formula (4b), $X^1$ and $X^2$ are each independently at least one selected from the group consisting of a hydrogen atom, an alkyl group having from 1 to 6 carbon atoms, and an alkylsilyl group having from 3 to 9 carbon atoms, preferably at least one selected from the group consisting of a hydrogen atom and an alkyl group having from 1 to 6 carbon atoms, more preferably a hydrogen atom.

From the viewpoints of thermal resistance and mechanical strength, the repeating unit represented by Formula (4b) is preferably 50 mol% or more and 100 mol% or less, more preferably 70 mol% or more and 100 mol% or less, with respect to all the repeating units of the polyimide resin precursor. The repeating unit is still more preferably 80 mol% or more and 100 mol% or less, even more preferably 90 mol% or more and 100 mol% or less, even more preferably 95 mol% or more and 100 mol% or less, even more preferably 99 mol% or more and 100 mol% or less, and it may be 100 mol%. The repeating unit is even more preferably 100 mol% from the viewpoints of thermal resistance and adhesion.

The polyimide resin precursor may include a repeating unit other than the repeating unit represented by Formula (4b).

The content of the repeating unit other than the repeating unit represented by Formula (4b) is preferably 50 mol% or less, more preferably 30 mol% or less, still more preferably 20 mol% or less, even more preferably 10 mol% or less, even more preferably 5 mol% or less, even more preferably 1 mol% or less, even more preferably 0 mol%, with respect to all the repeating units of the polyimide resin precursor, and it is even more preferable that no repeating unit other than the repeating unit represented by Formula (4b) is included.

As described above, the polyimide resin precursor even more preferably includes at least one selected from the group consisting of a repeating unit represented by Formula (4a), a repeating unit represented by Formula (5a), and a repeating unit represented by Formula (4b), even more preferably includes a repeating unit represented by Formula (4b). The inclusion of the repeating unit represented by Formula (4b) is preferable because the polyimide resin can be dissolved in any solvents, particularly in ester-based solvents, when varnishes are prepared.

When the polyimide resin precursor is an imide-amic acid copolymer, the precursor preferably includes the repeating units described in this section and the repeating units described in the section of the polyimide resin. Specifically, as the imide moiety, the precursor preferably includes at least one selected from the group consisting of a repeating unit represented by Formula (2b), a repeating unit represented by Formula (2a), and a repeating unit represented by Formula (3a), more preferably includes at least one selected from the group consisting of a repeating unit represented by Formula (2b) and a repeating unit represented by the Formula (2a) set forth below, still more preferably includes a repeating unit represented by Formula (2b). Specifically, as the amic acid moiety, the precursor preferably includes at least one selected from the group consisting of a repeating unit represented by Formula (4b), a repeating unit represented by Formula (4a), and a repeating unit represented by Formula (5a), more preferably includes at least one selected from the group consisting of a repeating unit represented by Formula (4b) and a repeating unit represented by the Formula (4a) set forth below, still more preferably includes a repeating unit represented by Formula (4b).

<Varnish>

The laminate of the present invention is preferably obtained by a method for producing a laminate, the method including a step of applying a polyimide resin varnish or a polyimide resin precursor varnish onto a support substrate and heating to obtain a polyimide resin layer, and a step of depositing, on the polyimide resin layer, an inorganic layer having a compressive stress.

Hereinafter, the varnishes used in the production of the laminate will be described, but preferable varnishes are the same for both the varnish containing the polyimide resin and the organic solvent constituting the polyimide resin layer and the varnish containing the precursor of the polyimide resin and the organic solvent constituting the polyimide resin layer. Thus, the varnishes will be collectively described as "varnish" below.

The varnish contains the polyimide resin and an organic solvent, or contains a polyimide resin precursor and an organic solvent.

The solvent is not particularly limited as long as it dissolves the polyimide resin or the polyimide resin precursor, but it is preferable to use the above-described compounds as the solvents used for producing the polyimide resin or the polyimide resin precursor alone or as a mixture of two or more types. Among the solvents described above, at least one selected from the group consisting of a cyclic amide, a chain amide, and a cyclic ester is preferably contained, a cyclic amide is more preferably contained, and N-methylpyrrolidone is still more preferably contained.

The varnish may be the polyimide resin solution or the polyimide resin precursor solution itself obtained by the above-described method for producing a polyimide resin or a polyimide resin precursor, may be obtained by further adding a solvent, or may be obtained by reducing the solvent through condensation or the like.

In the case of a varnish containing a polyimide resin precursor, the varnish can further contain an imidization catalyst and a dehydration catalyst from the viewpoint of efficiently progressing the imidization of the amic acid moiety. The imidization catalyst may have a boiling point of 40°C or higher and 180°C or lower, and is preferably an amine compound having a boiling point of 180°C or lower. The imidization catalyst with the boiling point of 180°C or lower is unlikely to cause coloration of the polyimide film during drying at a high temperature after the formation of the film, and thus such a catalyst does not impair the appearance of the laminate. In addition, in the case of an imidization catalyst having a boiling point of 40°C or higher, it is possible to avoid the possibility of volatilization of the imidization catalyst before sufficient imidization progresses.

Examples of the amine compound preferably used as the imidization catalyst include pyridines and picolines. The imidization catalysts described above may be used alone, or two or more types thereof may be used in combination.

Examples of the dehydration catalyst include: acid anhydrides such as acetic anhydride, propionic anhydride, n-butyric anhydride, benzoic anhydride, and trifluoroacetic anhydride; and carbodiimide compounds such as dicyclohexylcarbodiimide. These compounds may be used alone, or two or more types thereof may be used in combination.

Since the polyimide resin or the polyimide resin precursor contained in the varnish has solvent solubility, the varnish can have a high concentration. The varnish preferably contains the polyimide resin or the polyimide resin precursor in an amount of from 1 to 40 mass%, more preferably from 3 to 40 mass%, still more preferably from 5 to 30 mass%. The viscosity of the varnish is preferably from 0.1 to 200 Pa·s, more preferably from 1 to 20 Pa·s. The viscosity of the varnish is a value measured at 25°C using an E-type viscometer.

In addition, the varnish may contain various additives, such as inorganic fillers, adhesion promoters, release agents, flame retardants, ultraviolet stabilizers, surfactants, leveling agents, defoaming agents, fluorescent brightening agents, crosslinking agents, polymerization initiators, and photosensitizers, in the range that does not impair required characteristics of a polyimide film.

<Inorganic layer>

The laminate of the present invention is a laminate including a support substrate and a polyimide resin layer on the support substrate, the laminate including an inorganic layer on the polyimide resin layer, in which the stress of the inorganic layer is a compressive stress.

The stress of the inorganic layer is a compressive stress.

The stress of the inorganic layer being a compressive stress means that the stress S of the inorganic layer calculated by the following Stoney's equation has a negative value. The laminate set forth below is a laminate in which a support substrate, a polyimide resin layer, and an inorganic layer are laminated in this order, and the preliminary laminate is a laminate in which the support substrate and the polyimide resin layer are laminated in this order before the inorganic layer is laminated.

[Equation 1]

$$S = \frac{Eh^2}{(1-\nu)6t} \cdot \left(\frac{1}{R2} - \frac{1}{R1}\right) \quad \text{(Stoney's equation)}$$

(In the equation,

S is a stress of the inorganic layer (average value) (Pa),
E/(1 - v) is a biaxial elastic modulus of the preliminary laminate (support substrate/polyimide resin layer) (Pa),
h is a thickness of the preliminary laminate (support substrate/polyimide resin layer) (m),
t is a thickness of the inorganic layer (m),

R1 is a radius of curvature of the preliminary laminate (support substrate/polyimide resin layer) at 25°C, and R2 is a radius of curvature of the laminate (support substrate/polyimide resin layer/inorganic layer) at 25°C.)

Specifically, the stress of the inorganic layer can be calculated by the method described in Examples.
Since polyimide generally has a positive linear expansion coefficient, the polyimide resin layer exhibits a positive stress. Since the polyimide resin layer of the laminate of the present invention includes a structure derived from a specific acid dianhydride and a specific diamine, the thermal resistance of the resin itself is excellent, and the film-deposition properties of the inorganic layer are excellent. Further, the stress of the entire laminate is relaxed by depositing an inorganic layer having a compressive stress, and thus the laminate of the present invention is excellent in annealing resistance, that is, thermal resistance, and is useful as a laminate in the semiconductor process.
The inorganic layer preferably contains silicon. The inorganic layer more preferably contains at least one selected from the group consisting of silicon oxides and silicon nitrides, and still more preferably contains a silicon nitride. The inorganic layer is more preferably composed of at least one selected from the group consisting of silicon oxides and silicon nitrides. The inorganic layer is still more preferably a silicon oxide or a silicon nitride, even more preferably a silicon nitride. When the inorganic layer is silicon nitride, the effect of the present invention can be sufficiently exhibited, and excellent film-deposition properties and thermal resistance are obtained. Further, because silicon nitride is also excellent in barrier properties and chemical stability, the inorganic layer is excellent as an inorganic layer used for the laminate of the present invention.
The inorganic layer is an insulating layer. That is, the inorganic layer functions as an insulating layer and at the same time as a barrier layer in the laminate, and also functions as a buffer layer.
The thickness of the inorganic layer is preferably from 1 to 1,000 nm, more preferably from 1 to 400 nm, still more preferably from 10 to 300 nm, even more preferably from 20 to 200 nm, even more preferably from 50 to 150 nm. When the thickness of the inorganic layer is within the range, the effect of the present invention can be sufficiently exhibited, and excellent film-deposition properties and thermal resistance are obtained.

[Method for producing laminate]

The laminate of the present invention may be obtained by any production methods as long as it has the constitution described above, but it is preferably produced by the following method.
Specifically, the laminate is preferably produced by a method for producing a laminate, the method including a step of obtaining a polyimide resin layer by applying a polyimide resin varnish or a polyimide resin precursor varnish onto a support substrate and heating, and a step of depositing, on the polyimide resin layer, an inorganic layer having a compressive stress.
The support substrate, the polyimide resin varnish, the polyimide resin precursor varnish, the polyimide resin, the polyimide resin precursor, and the inorganic layer in the present production method are as described above in the present specification, and preferable ranges are also as described above in the present specification.

(Step of obtaining polyimide resin layer)

The present production method first includes a step of obtaining a polyimide resin layer by applying a polyimide resin varnish or a polyimide resin precursor varnish onto a support substrate and heating.
Through this step, a preliminary laminate in which the polyimide resin layer is laminated on the support substrate is obtained. An inorganic layer is deposited on the preliminary laminate in the next step to form the laminate of the present invention.
The heating temperature is preferably 300°C or higher, more preferably from 300 to 500°C. The heating time is usually from 1 minute to 6 hours, preferably from 10 minutes to 3 hours, more preferably from 20 minutes to 2 hours.
To remove the solvent contained in the varnish, preheating may be performed at from 60 to 250°C before heating to 300°C or higher. The preheating temperature is preferably from 60 to 250°C, more preferably from 70 to 180°C. The preheating time is preferably from 1 minute to 6 hours, more preferably from 5 minutes to 2 hours, still more preferably from 10 minutes to 1 hour. The preheating may be performed a plurality of times.
The heating atmosphere includes air, nitrogen gas, oxygen gas, hydrogen gas, nitrogen/hydrogen mixed gas, and the like, and to suppress the coloration of the resulting polyimide resin, nitrogen gas with an oxygen concentration of 100 ppm or less or nitrogen/hydrogen mixed gas containing hydrogen at a concentration of 0.5% or less is preferable.

(Step of depositing inorganic layer)

The laminate of the present invention includes a polyimide resin layer on a support substrate, and includes an inorganic layer on the polyimide resin layer, in which the stress of the inorganic layer is a compressive stress.

In this step, an inorganic layer having a compressive stress is deposited on the polyimide resin layer of the preliminary laminate obtained in the previous step.

The inorganic layer may be deposited by any methods, but is preferably formed by sputtering, CVD deposition, or vacuum vapor deposition. That is, the deposition method of an inorganic layer is preferably sputtering, CVD deposition, or vacuum vapor deposition, more preferably sputtering or CVD deposition, still more preferably CVD deposition. Even more preferably, the film is formed by plasma CVD deposition.

The deposition conditions for plasma CVD deposition for depositing an inorganic layer having a compressive stress are preferably the following conditions.

The plasma generation power supply frequency may be a frequency used in a general plasma processing apparatus, and may be appropriately adjusted depending on other conditions, but it is preferable to use 380 kHz, it is more preferable to use 380 kHz and 13.56 MHz in combination, and it is still more preferable to use 380 kHz and 13.56 MHz by alternately switching them.

The RF output is preferably from 20 to 60 W, more preferably from 20 to 50 W, still more preferably from 20 to 40 W.

The deposition temperature is preferably from 200 to 400°C, more preferably from 200 to 360°C.

The deposition time may be appropriately selected depending on the type of the raw material of the inorganic layer, the required layer thickness, and the like, and is preferably from 1 to 20 minutes, more preferably from 3 to 15 minutes.

The laminate thus obtained is excellent in layer-deposition properties and further excellent in thermal resistance, and thus is useful as a laminate in the semiconductor process. That is, the obtained laminate is useful as a laminate for semiconductor memories, laminating LSIs, CMOS image sensors, MEMS sealing, optical devices, LED applications, and the like.

## Examples

Hereinafter, the present invention will be specifically described with reference to Examples. However, the present invention is not limited in any way by these Examples.

### <Physical properties of polyimide resin>

#### (1) Glass transition temperature of polyimide resin

The glass transition temperature of the polyimide resin constituting the polyimide resin layer in the laminates of Examples and Comparative Examples was measured as follows.

The polyamic acid varnish obtained in (Production of polyamic acid varnish) of each of Examples and Comparative Examples was applied onto a support substrate (4 inch silicon wafer), held on a hot plate at 100°C for 10 minutes, then heated to 400°C at a temperature increasing rate of 5°C/min in a nitrogen atmosphere in a hot air dryer, and heated at 400°C for 30 minutes to evaporate the solvent and thermally imidize the solvent, whereby a polyimide film (thickness: 10 $\mu$m) was obtained.

For the obtained polyimide film, using a thermomechanical analyzer "TMA 7100C" manufactured by Hitachi High-Tech Science Corporation, the temperature was raised from 40°C to 500°C under the conditions of a sample size of 4 mm $\times$ 20 mm, a load of 50 mN, and a temperature increasing rate of 10°C/min in a tensile mode to perform TMA measurement, and a point where an inflection point of elongation was observed by extrapolation was defined as a glass transition temperature (Tg). The larger the value of the glass transition temperature (Tg), the better the thermal resistance.

The glass transition temperature of the polyimide resin is presented in Table 1.

### <Physical properties of inorganic layer>

#### (1) Stress of inorganic layer

The radius of curvature R1 at 25°C of the preliminary laminate (support substrate/polyimide resin layer) obtained in (Production of preliminary laminate) of each of Examples and Comparative Examples was measured using a residual stress measuring apparatus "FLX-2320-S" (manufactured by KLA-Tencor Corporation).

Next, as described later, an inorganic layer (silicon nitride layer) was deposited on the polyimide resin layer of the preliminary laminate (support substrate/polyimide resin layer) under the conditions of each of Examples and Comparative Examples, whereby a laminate (support substrate/polyimide resin layer/inorganic layer) was obtained.

Thereafter, the radius of curvature R2 of the obtained laminate (support substrate/polyimide resin layer/inorganic layer) at 25°C was measured using a residual stress measuring apparatus "FLX-2320-S" (manufactured by KLA-Tencor Corporation).

Using R1 and R2 obtained as described above, the stress S of the inorganic layer was calculated from the following Stoney's equation. The stress S is a stress generated between the preliminary laminate and the inorganic layer. A positive value of the stress S indicates a tensile stress, and a negative value indicates a compressive stress.

[Equation 2]

$$S = \frac{Eh^2}{(1-\nu)6t} \cdot \left(\frac{1}{R2} - \frac{1}{R1}\right) \qquad \text{(Stoney's equation)}$$

(In the equation,

S is a stress of the inorganic layer (average value) (Pa),
E/(1 - v) is a biaxial elastic modulus of the preliminary laminate (Pa),
h is a thickness of the preliminary laminate (m), and
t is a thickness of the inorganic layer (m).

As described above, R1 is the radius of curvature of the preliminary laminate (support substrate/polyimide resin layer) at 25°C, and R2 is the radius of curvature of the laminate (support substrate/polyimide resin layer/inorganic layer) at 25°C.)

In the present Examples, the biaxial elastic modulus of the preliminary laminate was approximated by the biaxial elastic modulus of the support substrate because the influence of the polyimide layer was extremely small.

<Process evaluation>

The process evaluation for the laminate was performed by the following method.

(1) Inorganic layer-deposition property (evaluation of film-deposition property)

The presence or absence of cracks in the inorganic layer of the laminate (support substrate/polyimide resin layer/inorganic layer) obtained in each of Examples and Comparative Examples was visually evaluated. Those in which no cracks were observed as a result of the evaluation without using a microscope were further evaluated with a microscope (magnification: 100 times). The smaller the size of the crack, the less the defects at the time of film deposition, the higher the thermal resistance, and the better the properties. A laminate with no cracks has no defect at the time of film deposition, thermal resistance is higher, and the properties are better.

A: No cracks are observed in the inorganic layer even when the inorganic layer is magnified 100 times with a microscope.

C: No cracks are visually observed in the inorganic layer, but cracks are observed in the inorganic layer when the inorganic layer is magnified 100 times with a microscope.

D: Cracks are visually observed in the inorganic layer.

(2) Annealing resistance (evaluation of thermal resistance)

The laminate (support substrate/polyimide resin layer/inorganic layer) obtained in each of Examples and Comparative Examples was heated and annealed at 400°C for 1 hour.

The presence or absence of cracks in the inorganic layer of the laminate (support substrate/polyimide resin/inorganic layer) was visually evaluated. The evaluation was made visually and microscopically. Those in which no cracks were observed as a result of the evaluation without using a microscope were further evaluated with a microscope (magnification: 100 times). The smaller the size of the crack, the less the defects at the time of film deposition, the higher the thermal resistance, and the better the properties. A laminate with no cracks has no defect at the time of film deposition, thermal resistance is higher, and the properties are better.

A: No cracks are observed in the inorganic layer even when the inorganic layer is magnified 100 times with a microscope.

C: No cracks are visually observed in the inorganic layer, but cracks are observed in the inorganic layer when the inorganic layer is magnified 100 times with a microscope.

D: Cracks are visually observed in the inorganic layer.

The tetracarboxylic acid component and diamine component used in Examples and Comparative Examples, and

the abbreviations thereof are as follows.

<Tetracarboxylic acid component>

ODPA: 4,4'-oxydiphthalic anhydride (manufactured by MANAC Incorporated, a compound represented by Formula (a1))
s-BPDA: 3,3',4,4'-biphenyltetracarboxylic dianhydride (manufactured by Mitsubishi Chemical Corporation, a compound represented by Formula (a2))
DSDA: 3,3',4,4'-diphenylsulfonetetracarboxylic dianhydride (manufactured by ChinaTech Chemical (Tianjin) Co., Ltd., a compound represented by Formula (a3))
PMDA: Pyromellitic anhydride (manufactured by Tokyo Chemical Industry Co., Ltd.)

<Diamine component>

4-BAAB: 4-aminophenyl-4-aminobenzoate (manufactured by Nipponjunryo Chemicals Co., Ltd., a compound represented by Formula (b1))
APTP: bis(4-aminophenyl)terephthalate (manufactured by Tokyo Chemical Industry Co., Ltd., a compound represented by Formula (b2))

Abbreviations of the solvents and catalysts used in Examples and Comparative Examples are as follows.

NMP: N-methyl-2-pyrrolidone (manufactured by Tokyo Pure Chemical Industries, Co., Ltd.)
GBL: $\gamma$-butyrolactone (manufactured by Mitsubishi Chemical Corporation)

<Production of laminate (support substrate/polyimide resin layer/inorganic layer)>

Example 1

(Production of polyamic acid varnish)

A 1 L five-neck round-bottom flask provided with a semilunar-shaped stirring blade made of stainless steel, a nitrogen inlet tube, a Dean-Stark apparatus equipped with a condenser, a thermometer, and an end cap made of glass was charged with 34.836 g (0.100 mol) of APTP and 294.927 g of NMP, the mixture was stirred at a rotational speed of 200 rpm in a nitrogen atmosphere with a system temperature of 50°C, and a solution was obtained.
To this solution, 15.511 g (0.050 mol) of ODPA, 14.711 g (0.050 mol) of s-BPDA, and 73.732 g of NMP were collectively charged, and stirred for 3 hours while being maintained at 50°C with a mantle heater, thereafter 108.429 g of NMP was charged, whereby a polyamic acid varnish having a solids content concentration of 12 mass% was obtained.

(Production of preliminary laminate)

Subsequently, the obtained polyamic acid varnish was applied onto a support substrate (4 inch silicon wafer, thickness 525 $\mu$m $\pm$ 25 $\mu$m), and held on a hot plate at 80°C for 20 minutes. Thereafter, the temperature was raised to 400°C at a temperature increasing rate of 5°C/min in a nitrogen atmosphere in a hot air dryer. Heating was performed at 400°C for 60 minutes, the solvent was evaporated, thermal imidization was performed to form a polyimide resin layer (thickness: 10 $\mu$m) on the support substrate, whereby a preliminary laminate (support substrate/polyimide resin layer) was obtained. Here, the "radius of curvature R1" was measured.

(Production of laminate)

Next, an inorganic layer (silicon nitride layer) was deposited on the polyimide resin layer of the preliminary laminate (support substrate/polyimide resin layer) under the conditions set forth below, whereby a laminate (support substrate/polyimide resin layer/inorganic layer) was obtained. The evaluation results of the obtained laminates are presented in Table 1.

(Inorganic layer deposition conditions)

- Apparatus: plasma CVD apparatus MPX-CVD manufactured by Sumitomo Precision Products Co., Ltd.
- Layer deposition method: PE-CVD
- Layer thickness: 1000 Å
- Upper electrode temperature: 250°C
- Lower electrode temperature: 350°C
- Layer deposition time: 8 minutes 15 seconds
- Plasma generation power supply frequency: 13.56 MHz (HF) and 380 kHz (LF) were alternately switched. 13.56 Hz (HF) for 7 seconds and 380 kHz (LF) for 4 seconds were regarded as 1 cycle, and 45 cycles were applied. In Table 1, this cycle is written as "HFLF".
- RF output: 30W
- Gas flow rate: $SiH_4/NH_3/N_2$ = 10/10/2000 sccm

Example 2

A laminate (support substrate/polyimide resin layer/inorganic layer) was obtained in the same manner as in Example 1 except that the plasma generation power supply frequency was changed to 380 kHz (LF) in the inorganic layer (silicon nitride layer) deposition conditions. The evaluation results of the obtained laminates are presented in Table 1.

Example 3

In producing a polyamic acid varnish, the polyamic acid varnish having a solids content concentration of 12 mass% was obtained in the same manner as in Example 1 except that ODPA and s-BPDA were changed to 35.828 g (0.100 mol) of DSDA, APTP was changed to 22.825 g (0.100 mol) of 4-BAAB, NMP as a solvent was changed to GBL, and the amount of GBL to be diluted was changed. Next, a laminate (support substrate/polyimide resin layer/inorganic layer) was obtained in the same manner as in Example 2 except that the polyamic acid varnish obtained here was used. The evaluation results of the obtained laminates are presented in Table 1.

Example 4

A laminate (support substrate/polyimide resin layer/inorganic layer) was obtained in the same manner as in Example 2 except that the film deposition time was changed to 41 minutes 15 seconds, and the film thickness was changed to 5000 Å in the inorganic layer (silicon nitride layer) deposition conditions. The evaluation results of the obtained laminates are presented in Table 1.

Example 5

A laminate (support substrate/polyimide resin layer/inorganic layer) was obtained in the same manner as in Example 3 except that the film deposition time was changed to 41 minutes 15 seconds, and the film thickness was changed to 5000 Å in the inorganic layer (silicon nitride layer) deposition conditions. The evaluation results of the obtained laminates are presented in Table 1.

Example 6

A laminate (support substrate/polyimide resin layer/inorganic layer) was obtained in the same manner as in Example 2 except that ODPA and s-BPDA were changed to 25.080 g (0.070 mol) of DSDA and 6.544 g (0.030 mol) of PMDA, APTP was changed to 22.825 g (0.100 mol) of 4-BAAB, the film deposition time was changed to 41 minutes 15 seconds, and the film thickness was changed to 5000 Å in the inorganic layer (silicon nitride layer) deposition conditions. The evaluation results of the obtained laminates are presented in Table 1.

Example 7

A laminate (support substrate/polyimide resin layer/inorganic layer) was obtained in the same manner as Example 2 except that ODPA and s-BPDA were changed to 17.914 g (0.050 mol) of DSDA and 10.906 g (0.050 mol) of PMDA, and APTP was changed to 22.825 g (0.100 mol) of 4-BAAB. The evaluation results of the obtained laminates are

presented in Table 1.

Example 8

A laminate (support substrate/polyimide resin layer/inorganic layer) was obtained in the same manner as in Example 7 except that the film deposition time was changed to 41 minutes 15 seconds, and the film thickness was changed to 5000 Å in the inorganic layer (silicon nitride layer) deposition conditions. The evaluation results of the obtained laminates are presented in Table 1.

Comparative Example 1

A laminate (support substrate/polyimide resin layer/inorganic layer) was obtained in the same manner as in Example 1 except that the plasma generation power supply frequency was changed to 13.56 MHz (HF) in the inorganic layer (silicon nitride layer) deposition conditions. The evaluation results of the obtained laminates are presented in Table 1.

Comparative Example 2

A laminate (support substrate/polyimide resin layer/inorganic layer) was obtained in the same manner as in Comparative Example 1 except that the lower electrode temperature was changed to 400°C, and the RF output was changed to 70 W in the inorganic layer (silicon nitride layer) deposition conditions. The evaluation results of the obtained laminates are presented in Table 1.

[Table 1]

Table 1

| | | | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|---|
| Polyimide resin (*1) | Tetracarboxylic acid component | ODPA (a1) | 50 | 50 | - | 50 | - | - | - | - | 50 | 50 |
| | | s-BPDA (a2) | 50 | 50 | - | 50 | - | - | - | - | 50 | 50 |
| | | DSDA (a3) | - | - | 100 | - | 100 | 70 | 50 | 50 | - | - |
| | | PMDA | - | - | - | - | - | 30 | 50 | 50 | | |
| | Diamine component | 4-BAAB (b1) | - | - | 100 | - | 100 | 100 | 100 | 100 | - | - |
| | | APTP (b2) | 100 | 100 | - | 100 | - | - | - | - | 100 | 100 |
| | Glass transition temperature (°C) | | 445 | 445 | 439 | 445 | 439 | 423 | 424 | 424 | 445 | 445 |
| Inorganic layer (silicon nitride layer) deposition conditions | Layer deposition method | | CVD | CVD | CVD | CVD | CVD | CVD | CVD | CVD | CVD | CVD |
| | Layer thickness (Å) | | 1,000 | 1,000 | 1,000 | 5,000 | 5,000 | 5,000 | 1,000 | 5,000 | 1,000 | 1,000 |
| | Layer deposition temperature (°C) | | 350 | 350 | 350 | 350 | 350 | 350 | 350 | 350 | 350 | 400 |
| | Frequency | | HFLF | LF | LF | LF | LF | LF | LF | LF | HF | HF |
| | RF output (W) | | 30 | 30 | 30 | 30 | 30 | 30 | 30 | 30 | 30 | 70 |
| Stress of inorganic layer | | MPa | -150 | -300 | -350 | -500 | -500 | -500 | -350 | -500 | 550 | 60 |
| | | | Compressive stress | Compressive stress | Compressive stress | Compressive stress | Compressive stress | Compressive stress | Compressive stress | Compressive stress | Tensile stress | Tensile stress |
| Evaluation | Inorganic layer-deposition properties | Layer-deposition property evaluation | A | A | A | A | A | A | A | A | A | A |
| | Annealing resistance | Thermal resistance evaluation | A | A | A | A | A | A | A | A | C | C |
| (*1) The number in the column of Polyimide resin represents the mole ratio in each component. | | | | | | | | | | | | |

As presented in Table 1, it can be seen that the laminates of Examples are excellent in film-deposition properties and further excellent is thermal resistance. Thus, the laminate of the presesnt invention has the properties s described above and is therefore useful as a laminate in the semiconductor process. That is, the laminate of the present invention is useful as a laminate for semiconductor memories, laminating LSIs, CMOS image sensors, MEMS sealing, optical devices, LED applications, and the like.

## Claims

1. A laminate, comprising a support substrate, a polyimide resin layer on the support substrate, and an inorganic layer on the polyimide resin layer,
   wherein a glass transition temperature of a polyimide resin constituting the polyimide resin layer is 300°C or higher, and a stress of the inorganic layer is a compressive stress.

2. The laminate according to claim 1, wherein the inorganic layer contains silicon.

3. The laminate according to claim 1 or 2, wherein the inorganic layer comprises a silicon oxide or a silicon nitride.

4. The laminate according to any one of claims 1 to 3, wherein a film thickness of the polyimide resin layer is from 0.5 to 300 μm.

5. The laminate according to any one of claims 1 to 4, wherein a thickness of the inorganic layer is from 1 to 1,000 nm.

6. The laminate according to any one of claims 1 to 5, wherein the support substrate contains silicon.

7. The laminate according to any one of claims 1 to 6, wherein the support substrate comprises silicon, silicon carbide, gallium nitride, gallium oxide, aluminum nitride, or diamond.

8. A method for producing a laminate, the method comprising a step of obtaining a polyimide resin layer by applying a polyimide resin varnish or a polyimide resin precursor varnish onto a support substrate and heating, the method further comprising a step of depositing, on the polyimide resin layer, an inorganic layer having a compressive stress.

## INTERNATIONAL SEARCH REPORT

International application No.
**PCT/JP2024/028361**

**A. CLASSIFICATION OF SUBJECT MATTER**

***B32B 9/00***(2006.01)i; ***H01L 21/31***(2006.01)i; ***H01L 21/312***(2006.01)i; ***H01L 21/316***(2006.01)i; ***H01L 21/318***(2006.01)i
FI: B32B9/00 A; H01L21/31 C; H01L21/312 B; H01L21/316 X; H01L21/318 B

According to International Patent Classification (IPC) or to both national classification and IPC

**B. FIELDS SEARCHED**

Minimum documentation searched (classification system followed by classification symbols)

B32B1/00-43/00; H01L21/205-21/86

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2016-124246 A (FUJIFILM CORPORATION) 11 July 2016 (2016-07-11) claims, paragraphs [0031]-[0043], fig. 1 | 1-6, 8 |
| A | WO 2014/098235 A1 (ASAHI KASEI E-MATERIALS CORPORATION) 26 June 2014 (2014-06-26) whole document | 1-8 |
| A | JP 11-135727 A (SONY CORPORATION) 21 May 1999 (1999-05-21) whole document | 1-8 |
| A | JP 2002-343858 A (SONY CORPORATION) 29 November 2002 (2002-11-29) whole document | 1-8 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 September 2024** | **08 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/028361**

| Patent document cited in search report | Publication date (day/month/year) | Patent family member(s) | Publication date (day/month/year) |
|---|---|---|---|
| JP 2016-124246 A | 11 July 2016 | (Family: none) | |
| WO 2014/098235 A1 | 26 June 2014 | KR 10-2015-0086496 A | |
| | | TW 201434973 A | |
| JP 11-135727 A | 21 May 1999 | (Family: none) | |
| JP 2002-343858 A | 29 November 2002 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2014098235 A